# EUROPÄISCHE PATENTSCHRIFT

(11) **EP 1 423 648 B1**
(45) Veröffentlichungstag und Bekanntmachung des Hinweises auf die Patenterteilung: **06.12.2006**
(21) Anmeldenummer: 02797670.3
(22) Anmeldetag: 03.09.2002
(51) Int. Cl.: F25B 21/02, H01L 35/00

(54) **KÜHLVORRICHTUNG**
COOLING DEVICE
DISPOSITIF DE REFROIDISSEMENT

(30) Priorität: 03.09.2001 DE 10143116
(43) Veröffentlichungstag der Anmeldung: 02.06.2004
(73) Patentinhaber: BOHNENKAMP, Wolfram, 28779 Bremen (DE)
(72) Erfinder: BOHNENKAMP, Wolfram, 28779 Bremen (DE)
(74) Vertreter: Pfenning, Meinig & Partner GbR
(86) Internationale Anmeldenummer: PCT/EP2002/009859
(87) Internationale Veröffentlichungsnummer: WO 2003/021165

(56) Entgegenhaltungen:
- WO-A-00/25367
- WO-A-98/44562
- WO-A-99/04439
- WO-A-99/50604
- DE-A- 2 347 457
- US-A- 3 635 037
- PATENT ABSTRACTS OF JAPAN vol. 016, no. 388 (M-1297), 18. August 1992 (1992-08-18) -& JP 04 126973 A (TOSHIBA CORP), 27. April 1992 (1992-04-27)

## Beschreibung

Die Erfindung betrifft eine Kühlvorrichtung nach dem Oberbegriff des Anspruchs 1.

Peltierelemente werden vielfältig für Kühlzwecke eingesetzt. So werden zum Beispiel Mikroskoptische für Gefrierschnitte, Infrarotsensoren oder auch Kühlboxen durch Peltierelemente gekühlt. Dabei ist auf der warmen Seite meist ein Kühlkörper mit Luft umspült, während auf der kalten Seite das zu kühlende Teil aufgelötet oder mit Wärmeleitpaste versehen aufgeschraubt wird. Durch diese Konstruktion hat das Peltierelement eine deutlich höhere Temperaturdifferenz zu erzeugen als die effektive Differenz zwischen dem Kühlraum und der Umgebungsluft.

Um die erzeugte Temperaturdifferenz möglichst optimal zu nutzen, ist es notwendig, den Wärmetauscher am Peltierelement zu optimieren. Dies geschieht vorteilhaft mit Hilfe eines Flüssigkeitswärmetauschers, in welchem einer Flüssigkeit Wärme entzogen wird, um an anderer Stelle eine gewünschte Kühlleistung zu erbringen. Für den Transport der Flüssigkeit zwischen dem Wärmetauscher und dem zu kühlenden Bereich ist ein mechanisches Fördermittel wie eine motorgetriebene Pumpe erforderlich. Dies erhöht den Aufwand für die Kühlvorrichtung, erhöht den Energieverbrauch und kann Ursache für Funktionsstörungen sein.

Aus der WO 99/50604 und auch aus der nachveröffentlichten US 6 351 951 B1 ist eine Kühlvorrichtung mit einem Peltierelement bekannt, das mit einem Kreislauf für ein Arbeitsmedium zu dessen Kühlung thermisch gekoppelt ist. Der Kreislauf enthält senkrecht verlaufende Abschnitte, wobei das Arbeitsmedium, das beispielsweise aus Aceton bestehen kann, durch sein Gewicht im Kreislauf zirkulieren kann. Dies erfolgt auf Grund einer Phasenumwandlung "flüssig/gasförmig/flüssig" während eines Umlaufs. Das Peltierelement befindet sich an der höchsten Stelle des Kreislaufs.

Es ist die Aufgabe der vorliegenden Erfindung, eine Kühlvorrichtung mit mindestens zwei Peltierelementen, die mit mindestens zwei Flüssigkeitskreisläufen zur Kühlung der Flüssigkeit thermisch gekoppelt ist, wobei der Flüssigkeitskreislauf Abschnitte aufweist, die unter einem Winkel von weniger als 90° zur Richtung der Schwerkraft verlaufen, und eine Flüssigkeit mit einem hohen Wärmeausdehnungskoeffizienten enthält, zu schaffen, die besonders effizient arbeitet.

Diese Aufgabe wird erfindungsgemäß gelöst durch eine Kühlvorrichtung mit den Merkmalen des Anspruchs 1. Vorteilhafte Weiterbildungen der erfindungsgemäßen Kühlvorrichtung ergeben sich aus den Unteransprüchen.

Dadurch, dass der erste der Flüssigkeitskreisläufe mit der wärmeaufnehmenden Seite eines oder mehrerer erster Peltierelemente und mit der wärmeabgebenden Seite eines oder mehrerer zweiter Peltierelemente und der zweite der Flüssigkeitskreisläufe mit der wärmeaufnehmenden Seite des einen oder der mehreren zweiten Peltierelemente thermisch gekoppelt sind, wird eine optimale Ausnutzung der Wirkung der Peltierelemente erhalten.

Dadurch, daß der Flüssigkeitskreislauf Abschnitte aufweist, die unter einem Winkel von weniger als 90° zur Richtung der Schwerkraft verlaufen und eine Flüssigkeit mit einem hohen Wärmeausdehnungskoeffizienten enthält, treten im Flüssigkeitskreislauf temperaturabhängig erhebliche Dichteunterschiede auf, die in dem nicht senkrecht zur Richtung der Schwerkraft verlaufenden Abschnitte eine Zirkulation der Flüssigkeit bewirken. Es ist hierdurch möglich, ohne den Einsatz einer mechanischen Pumpe die Kühlleistung des Peltierelements auf eine große Fläche zu transferieren. Dies geschieht beispielsweise mittels eines Kupferrohres, das innerhalb des Kühlkreislaufs auf ein Blech gelötet ist oder in eine Flüssigkeit eintaucht, die als Kältespeicher fungiert. Am obersten Teil dieses Kreislaufs kann man ein Ausdehnungsgefäß installieren, damit das sich ändernde Volumen der Flüssigkeit ausgeglichen werden kann.

Die Flüssigkeit zirkuliert um so schneller, je größer die Temperaturdifferenz ist. Die Geschwindigkeit dieses Kreislaufes ist mitentscheidend für die Effizienz der Kühlvorrichtung, da hierdurch weniger wärmetransportierende Phonone (gequantelte Vibrationen der Kristallstruktur) durch die Halbleiter zurückgeleitet werden.

Der Bereich der thermischen Kopplung zwischen dem Peltierelement und dem Flüssigkeitskreislauf liegt vorzugsweise an dessen höchster Stelle, da hier die Flüssigkeit durch ihre Abkühlung die höchste Dichte annimmt und durch ihre Schwerkraft nach unten sinkt, wodurch die Zirkulation bewirkt wird.

Um eine aus wirtschaftlichen Gründen ausreichende Zirkulationsgeschwindigkeit zu erzielen, sollte der Wärmeausdehnungskoeffizient der Flüssigkeit im gesamten Temperaturbereich von -25°C bis +40°C zumindest 20 x 10⁻⁵ pro Grad, vorzugsweise mindestens 50 x 10⁻⁵ pro Grad, vorteilhafter mindestens 100 x 10⁻⁵ pro Grad und am vorteilhaftesten mindestens 130 x 10⁻⁵ pro Grad betragen. Zusätzlich sollte das Fließvermögen der Flüssigkeit möglichst groß sein, d.h. ihre Viskosität sollte im Bereich von -25°C bis +40°C geringer als 50 mP sein. Geeignete Flüssigkeiten, die diese Voraussetzungen erfüllen, sind beispielsweise Azeton (Wärmeausdehnungskoeffizient ca. 140 x 10⁻⁵ pro Grad) oder Siliconöl (Wärmeausdehnungskoeffizient ca. 105 x 10⁻⁵ pro Grad).

Die Erfindung wird im Folgenden anhand von in den Figuren dargestellten Ausführungsbeispielen näher erläutert. Es zeigen:
- Fig. 1: eine schematische Darstellung einer Kühlvorrichtung mit zwei thermisch hintereinander geschalteten Kühlkreisläufen,
- Fig. 2: einen Wärmetauscher zwischen einem Peltierelement und jeweils einem Flüssigkeitslauf auf der kalten und der warmen Seite des Peltierelements gemäß einem ersten Ausführungsbeispiel,
- Fig. 3: einen Wärmetauscher zwischen einem Peltierelement und jeweils einem Flüssigkeitskreislauf auf der kalten und der warmen Seite des Peltierelements gemäß einem zweiten Ausführungsbeispiel und
- Fig. 4: einen Wärmetauscher zwischen einem Peltierelement und jeweils einem Flüssigkeitskreislauf auf der kalten und der warmen Seite des Peltierelements gemäß einem dritten Ausführungsbeispiel.

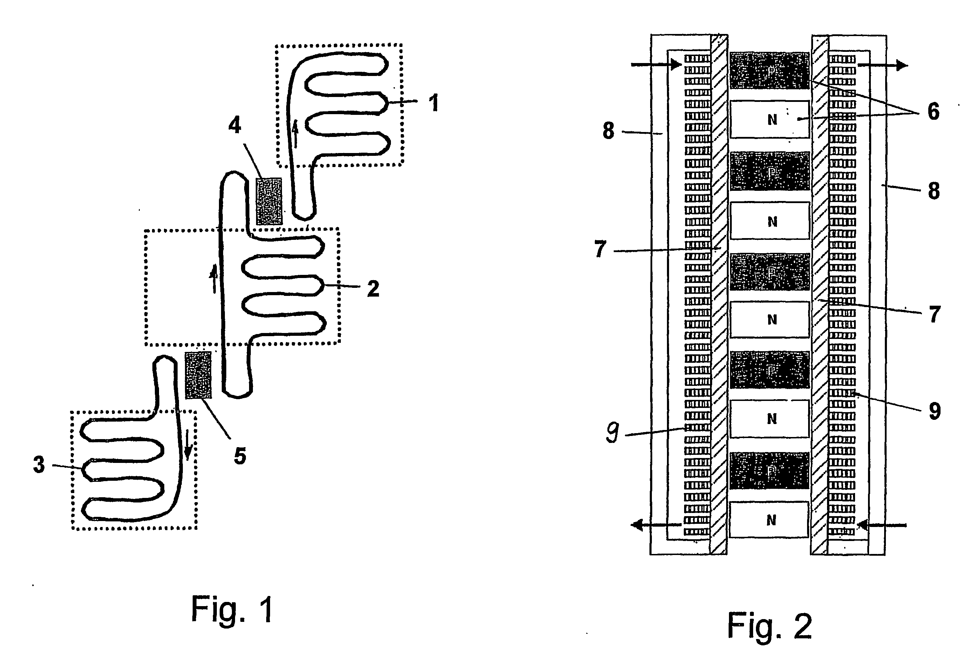

Die in Fig. 1 gezeigte Kühlvorrichtung stellt eine Kühl- und Gefrierkombination mit einem Flüssigkeitskreislauf 1 in einem Außenbereich, einem Flüssigkeitslauf 2 in einem Kühlbereich und einem Flüssigkeitskreislauf 3 in einem Gefrierbereich dar. Ein Peltierelement 4 ist auf seiner wärmeabgebenden Seite mit dem Flüssigkeitskreislauf 1 und auf seiner wärmeaufnehmenden Seite mit dem Flüssigkeitskreislauf 2 thermisch gekoppelt. Ein Peltierelement 5 ist auf seiner wärmeabgebenden Seite mit dem Flüssigkeitskreislauf 2 und auf seiner wärmeaufnehmenden Seite mit dem Flüssigkeitskreislauf 3 thermisch gekoppelt.

Bei dieser Konstruktion muss das beispielsweise zwischen 5°C und 25°C arbeitende Peltierelement 4 die "Joulesche Wärme" des beispielsweise zwischen -18°C und +5°C arbeitenden Peltierelements 5 übernehmen. Das Peltierelement 4 muss daher, wenn der Kühlbereich und der Gefrierbereich gleiches Volumen haben, größer als das Peltierelement 5 sein (wobei zu berücksichtigen ist, daß bei verschiedenen Temperaturbereichen unterschiedliche Leistungskurven erhalten werden).

Dies kann dadurch ausgeglichen werden, daß das Peltierelement 4 eine größere Anzahl von Einzelelementen aufweist. Eine andere Möglichkeit besteht darin, die Peltierelemente bei einem anderen "Arbeitspunkt" zu betreiben, indem eine vorgegebene Gleichspannung (z.B. 12 V) an eine deutlich größere Anzahl von Einzelelementen (P/N-Leitern) gelegt wird. Damit würde der "Arbeitspunkt" von üblicherweise etwa 75 % der Maximalleistung herabgesetzt und die Effizienz gesteigert.

Der Flüssigkeitskreislauf 1 kann an der Außenseite eines Gebäudes installiert sein, z.B. an der nördlichen Außenseite eines Wohnhauses (Kühlschränke stehen meist Jahrzehnte an der selben Stelle, was einen Wanddurchbruch durchaus rechtfertigt). Das hätte eine deutlich verringerte Umgebungstemperatur, d.h. geringere Temperaturdifferenz am Peltierelement 4 zur Folge.

Verfügt die Einrichtung (z.B. Haus oder Schiff), in welcher die Kühlvorrichtung betrieben wird, über Sonnenkollektoren, so ist der Einsatz besonders sparsam, da in diesem Fall die Transformation und Gleichrichtung der Wechselstromversorgung mit der entsprechenden Verlustleistung entfällt.

Bei Schiffen ist es vorteilhaft, den (wärmsten) Flüssigkeitskreislauf 1 mit der Außenhaut unter der Wasserlinie in Verbindung zu bringen. Bei Aluminium- und Stahlschiffen ist es am einfachsten, eine entsprechende Kühlfläche zwischen zwei Spannten von innen mit einer zweiten Wand sowie Zu- und Ablauf zu versehen. Bei Kunststoffschiffen wird eine Reinkupferplatte mit schlangenförmigen Fräsungen mit einem Blech verschlossen und mit Zu- und Ablauf versehen von außen aufmontiert. In diesen Fällen befindet sich die Kühlvorrichtung - zumindest bei kleineren Sportschiffen - oberhalb der Wasserlinie. Man muss daher einen mechanisch gepumpten Kreislauf vorsehen. Als Medium kann man Wasser einsetzen, was den Vorteil hat, daß es einen etwa doppelten Wärmeinhalt pro Volumeneinheit im Vergleich zu organischen Flüssigkeiten hat. Daher kann das Pumpvolumen klein sein.

In Fig. 1 ist die jeweilige Strömungsrichtung der in den Kreisläufen 1, 2 und 3 zirkulierenden Flüssigkeit durch Pfeile angezeigt. Es ist darauf hinzuweisen, daß die thermische Kopplung zwischen den wärmeaufnehmenden (kühlenden) Seite eines Peltierelements und einem Flüssigkeitskreislauf an dessen höchster Stelle und diejenige zwischen der wärmeabgebenden Seite eines Peltierelements und einem Flüssigkeitskreislauf an dessen tiefster Stelle vorgesehen sind.

Um möglichst hohe, auf Schwerkraftunterschieden beruhende Zirkulationsgeschwindigkeiten der Flüssigkeit und damit einen hohen Wirkungsgrad des Wärmetauschers zu erzielen, sollte diese einen besonders großen Wärmeausdehnungskoeffizienten besitzen. Zweckmäßig sollte dieser im gesamten Temperaturbereich von -25°C bis +40°C größer als 20 x 10⁻⁵ pro Grad, vorzugsweise mindestens 50 x 10⁻⁵ pro Grad, vorteilhafter mindestens 100 x 10⁻⁵ pro Grad und am vorteilhaftesten mindestens 130 x 10⁻⁵ pro Grad sein. Auch die Viskosität der Flüssigkeit sollte 50 mP im Bereich von -25°C bis +40°C nicht überschreiten, um eine hohe Fließfähigkeit zu gewährleisten. Als geeignete Flüssigkeiten bieten sich Azeton oder Siliconöl an.

Fig. 2 zeigt eine spezielle Konstruktion eines Wärmetauschers zwischen einem aus mehreren P/N-Leiterpaaren 6 bestehenden Peltierelement und jeweils einem Flüssigkeitskreislauf auf der wärmeaufnehmenden (kühlenden) bzw. wärmeabgebenden Seite des Peltierelements. Die P/N-Leiterpaare 6 sind in bekannter Weise in Reihe an eine Gleichspannung von z.B. 12 V angeschlossen, wobei die elektrischen Verbindungen zwischen ihnen nicht dargestellt sind. Die Anzahl der P/N-Leiterpaare 6 beträgt beispielsweise 127. Die Gleichspannung ist so gepolt, daß in Fig. 2 die linke Seite die wärmeaufnehmende Seite und die rechte Seite die wärmeabgebende Seite sind. Die P/N-Leiterpaare 6 sind beidseitig mit Keramikplatten 7 aus Aluminiumoxid oder -nitrid, deren Wärmeleitfähigkeit im Bereich von 20 bis 100 W pro m und Grad Kelvin beträgt, thermisch gekoppelt. Fig. 2 zeigt ein sogenanntes offenes System, bei dem zur Bildung der Flüssigkeitskreisläufe jeweils Halbschalen 8 mit einem Zu- und Ablauf für die Flüssigkeit auf die Keramikplatten 7 aufgeklebt oder gelötet sind. Die Zu- und Abläufe am oberen bzw. unteren Ende der Halbschalen 8 und die entsprechende Strömungsrichtung der Flüssigkeit sind durch Pfeile angezeigt. Für die Halbschalen 8 ist ein Material zu verwenden, das einen ähnlichen thermischen Ausdehnungskoeffizienten (6,5 x 10⁻⁶ Grad⁻¹) wie das der Keramikplatten 7 hat.

Je nach eingesetzter Flüssigkeit und geforderter Kühlleistung kann es zweckmäßig sein, die Wärmetauscherfläche durch Kupferstrukturen 9 im von der Flüssigkeit durchströmten Raum zwischen den Keramikplatten 7 und den Halbschalen 8 zu vergrößern. Diese können aus Sintermaterial oder anderen Strukturen aus Reinkupfer bestehen, welche wärmeleitend auf die Keramikplatten 7 aufgelötet sind.

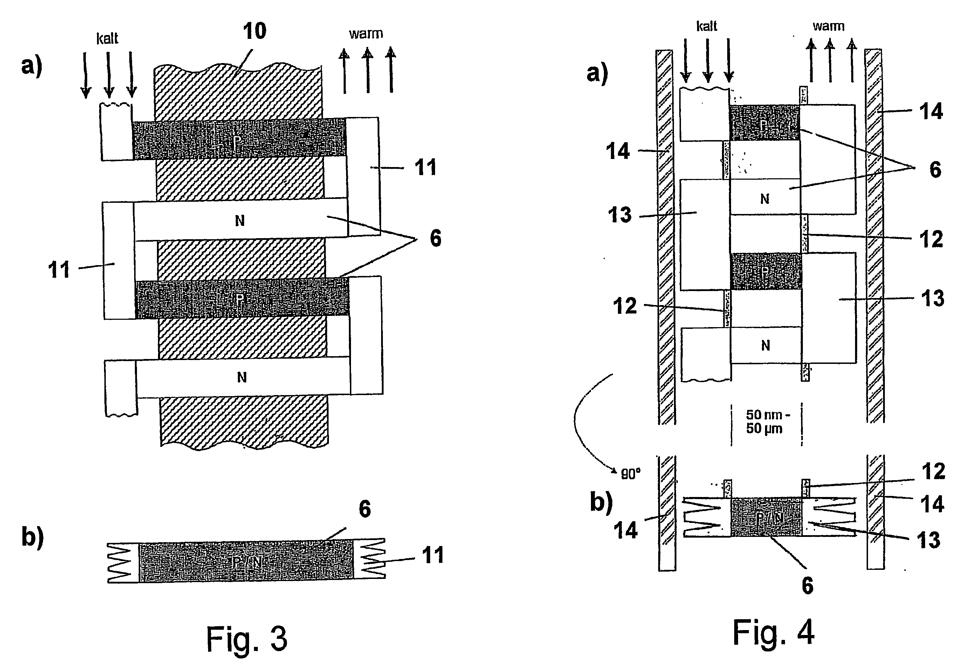

Fig. 3 zeigt eine weitere Ausführungsform eines Wärmetauschers als sogenanntes offenes System, bei der keine Keramikplatten zur Trennung der Flüssigkeitskreisläufe eingesetzt werden. Hierzu dient eine Trennwand 10, die aus einem oder mehreren mineralischen oder organischen Materialien (z.B. Vergussmasse) besteht und die einzelnen N/P-Leiterpaare 6 elektrisch isoliert zusammenhält. Die an die N/P-Leiter 6 angelöteten elektrischen Verbindungselemente 11 sind in direktem Kontakt mit der Flüssigkeit der beiden getrennten Kreisläufe auf jeweils einer Seite der Trennwand 10. Es ist daher nicht notwendig, die einzelnen Verbindungselemente 11 plan auszurichten. Vielmehr können diese durch Lamellen oder ähnliche Strukturen den Wärmeübergang zur Flüssigkeit erleichtern. Ein weiterer Vorteil besteht darin, daß eine unterschiedliche thermische Ausdehnung der N/P-Leiter weitgehend unschädlich ist.

Die beiden Flüssigkeitskreisläufe werden im Bereich des Wärmetauschers wie in Fig. 2 dargestellt auf der Außenseite durch nicht gezeigte Halbschalen begrenzt.

Fig. 3b) gibt einen P- bzw. N-Leiter 6 in gegenüber Fig. 3a) in einer um eine horizontale Achse um 90° gedrehter Lage wieder. Es ist zu erkennen, daß die Verbindungselemente 11 in Form von Kühlrippen ausgebildet sind, um den Wärmeaustausch mit der Flüssigkeit erleichtern.

In Fig. 4 ist das Peltierelement aus N/P-Leitern 6 gebildet, die aus sehr dünnen aufgedampften Schichten mit einer Dicke im Bereich 50 nm bis 50 µm bestehen, wie in der US 6 300 150 B1 beschrieben ist. Ein derart ausgestaltetes Peltierelement hat einen deutlich höheren Wirkungsgrad als ein herkömmliches Peltierelement. Da die dünnen N/P-Leiter 6 mechanisch wenig belastbar sind, müssen diese von einer Trägerkonstruktion gehalten werden, die auch dazu dient, die beiden Flüssigkeitskreisläufe voneinander zu trennen. Hierzu ist eine elektrische Isoliermatrix 12 beispielsweise aus einem Epoxid vorgesehen, die einseitig oder wie in Fig. 4 gezeigt beidseitig der P/N-Leiter 6 angeordnet sein kann. Die die P/N-Leiter 6 elektrisch verbindenden Verbindungselemente bestehen aus ebenfalls von der Isoliermatrix 12 getragenen Kupferlamellen 13, die von der elektrisch nicht leitenden Flüssigkeit der voneinander getrennten Kreisläufe umströmt werden und damit auch den Wärmeaustausch fördern. Außenwände 14 bilden die äußeren Begrenzungen der beiden Flüssigkeitskreisläufe.

Wie Fig. 4b), die die um 90° um eine horizontale Achse gegenüber der Darstellung nach Fig. 4a) gedrehten P/N-Leiter 6 zeigt, erkennen lässt, sind auch die Kupferlamellen 13 mit Einschnitten versehen, um ihre Wärmetauschwirkung zu erhöhen.

Die Ausbildung des Wärmetauschers ist nicht auf die in den Fign. 2 - 4 gezeigten Ausführungsformen beschränkt. So ist auch eine geschlossene Konstruktion aus Reinkupfer mit Rohranschlüssen am oberen und unteren Ende denkbar, die mit Wärmeleitpaste versehen auf das Peltierelement aufgeschraubt ist. Der von der Flüssigkeit durchströmte Innenraum dieser Konstruktion kann mit Sintergut (sogenanntes "Cut Wire"-Material) gefüllt sein, um die Wärmetauscherfläche zu vergrößern. Die Oberfläche kann jedoch auch auf jede andere bekannte Weise vergrößert werden. Eine andere geschlossene Konstruktion enthält eine feste Halbschale, die den notwendigen Anpressdruck über Sintergut oder andere Strukturen auf eine Reinkupferplatte und das Peltierelement erbringt. Die hat den Vorteil, daß die Kupferplatte am Peltierelement besonders dünn sein kann und daher einen besonders geringen Wärmewiderstand hat.

## Patentansprüche

1. Kühlvorrichtung mit mindestens zwei Peltierelementen (4,5), die mit mindestens zwei Flüssigkeitskreisläufen (2,3) zur Kühlung der Flüssigkeit thermisch gekoppelt sind, wobei mindestens ein Flüssigkeitskreislauf (2,3) Abschnitte aufweist, die unter einem Winkel von weniger als 90° zur Richtung der Schwerkraft verlaufen, und eine Flüssigkeit mit einem hohen Wärmeausdehnungskoeffizienten enthält,
**dadurch gekennzeichnet,**
**dass** der erste (2) der Flüssigkeitskreisläufe mit der wärmeaufnehmenden Seite eines oder mehrerer erster Peltierelemente (4) und mit der wärmeabgebenden Seite eines oder mehrerer zweiter Peltierelemente (5) und der zweite (3) der Flüssigkeitskreisläufe mit der wärmeaufnehmenden Seite des einen oder der mehreren zweiten Peltierelemente (5) thermisch gekoppelt sind.

2. Kühlvorrichtung nach Anspruch 1, **dadurch gekennzeichnet, dass** ein dritter Flüssigkeitskreislauf (1) vorgesehen ist, der mit der wärmeabgebenden Seite des einen oder der mehreren ersten Peltierelemente (4) und mit einem Außenbereich thermisch gekoppelt ist.

3. Kühlvorrichtung nach Anspruch 1 oder 2, **dadurch gekennzeichnet, dass** die thermische Kopplung zwischen der wärmeabgebenden Seite eines Peltierelements (4,5) und einem Flüssigkeitskreislauf (1,2) an dessen tiefster Stelle vorgesehen ist.

4. Kühlvorrichtung nach Anspruch 2, **dadurch gekennzeichnet, dass** sich der Außenbereich auf einer Gebäudeaußenseite befindet.

5. Kühlvorrichtung nach Anspruch 2, **dadurch gekennzeichnet, dass** sich der Außenbereich auf einer Schiffsaußenseite unterhalb der Wasserlinie und unterhalb des Bereichs der thermischen Kopplung mit dem einen oder den mehreren ersten Peltierelementen (4) befindet und eine Pumpe für die Zirkulation der Flüssigkeit in dem dritten Flüssigkeitskreislauf (1) vorgesehen ist.

6. Kühlvorrichtung nach Anspruch 1, **dadurch gekennzeichnet, dass** die Flüssigkeit direkt mit Verbindungselementen (14) von N/P-Leitern (6) des einen oder der mehreren zweiten Peltierelemente (5) auf dessen wärmeaufnehmender und/oder -abgebender Seite in Kontakt ist, wobei die beiden Flüssigkeitskreisläufe (2,3) durch mindestens eine die Zwischenräume zwischen den N/P-Leitern (6) abdichtende Schicht (10) voneinander getrennt sind.

7. Kühlvorrichtung nach Anspruch 2, **dadurch gekennzeichnet, dass** der Flüssigkeitskreislauf (2,3) einen Kältepuffer enthält.

## Claims

1. Cooling means with at least two Peltier elements (4, 5), which are thermally coupled with at least two fluid cycles (2, 3) for cooling the fluid, whereby at least one fluid cycle (2 ,3) comprises sections that extend at an angle of less than 90° from the direction of gravity, and which contain a fluid with a high heat expansion coefficient, **characterised in that** the first (2) of the fluid cycles is thermally coupled with the heat receiving side of one or more first Peltier element(s) (4), and with the heat emitting side of one or more second Peltier element(s) (5), and **in that** the second (3) of the fluid cycles is thermally coupled with the heat receiving side of the one or more second Peltier element(s) (5).

2. Cooling means according to Claim 1, **characterised in that** a third fluid cycle (1) is envisaged, which is thermally coupled with the heat emitting side of the one or more first Peltier element(s) (4) and with an outer section.

3. Cooling means according to Claim 1 or 2, **characterised in that** the thermal coupling between the heat emitting side of a Peltier element (4, 5) and a fluid cycle (1, 2) is envisaged at its deepest point.

4. Cooling means according to Claim 2, **characterised in that** the outer section is located on an outside of a building.

5. Cooling means according to Claim 2, **characterised in that** the outer section is located on the outside of a ship below the waterline and below the thermal coupling with the one or more Peltier element(s) (4), and **in that** a pump is envisaged for the circulation of fluid in the third fluid cycle (1).

6. Cooling means according to Claim 1, **characterised in that** the fluid is in direct contact with the connection elements (14) of N/P conductors (6) of the one or more second Peltier element(s) (5) on the heat receiving and/or emitting side of the same, whereby the two fluid cycles (2, 3) are separated from each other by at least one layer (10) sealing the gaps between the N/P conductors (6).

7. Cooling means according to Claim 2, **characterised in that** the fluid cycle (2, 3) comprises a cold buffer.

## Revendications

1. Dispositif de refroidissement comportant au moins deux éléments Peltier (4, 5), qui sont couplés thermiquement à au moins deux circuits de liquide (2, 3) pour refroidir le liquide, au moins un circuit de liquide (2, 3) comportant des parties qui s'étendent en formant un angle inférieur à 90° par rapport à la direction de la force de gravité, et contenant un liquide avec un coefficient de dilatation thermique élevé, **caractérisé en ce que** le premier (2) des circuits de liquide est couplé thermiquement avec le côté d'absorption de chaleur d'un ou de plusieurs premiers éléments Peltier (4) et avec le côté d'émission de chaleur d'un ou de plusieurs deuxièmes éléments Peltier (5), et le deuxième (3) des circuits de liquide est couplé thermiquement avec le côté d'absorption de chaleur d'un ou de plusieurs deuxièmes éléments Peltier (5).

2. Dispositif de refroidissement selon la revendication 1, **caractérisé en ce qu'**il est prévu un troisième circuit de liquide (1) qui est couplé thermiquement avec le côté d'émission de chaleur du ou des plusieurs premiers éléments Peltier (4) et avec une zone extérieure.

3. Dispositif de refroidissement selon la revendication 1 ou 2, **caractérisé en ce que** le couplage thermique entre le côté d'émission de chaleur d'un élément Peltier (4, 5) et un circuit de liquide (1, 2) est prévu à l'emplacement le plus bas de celui-ci.

4. Dispositif de refroidissement selon la revendication 2, **caractérisé en ce que** la zone extérieure se situe sur une face extérieure du bâtiment.

5. Dispositif de refroidissement selon la revendication 2, **caractérisé en ce que** la zone extérieure se situe sur une face extérieure d'un bateau en dessous de la ligne de flottaison et en dessous de la zone du couplage thermique avec le ou les plusieurs des premiers éléments Peltier (4), et une pompe pour la circulation du liquide est prévue dans le troisième circuit de liquide (1).

6. Dispositif de refroidissement selon la revendication 1, **caractérisé en ce que** le liquide est en contact direct avec les éléments de liaison (14) de conducteurs de type N et P (6) du ou des plusieurs deuxièmes éléments Peltier (5) sur le côté d'absorption de chaleur et/ou le côté d'émission de chaleur de ceux-ci, les deux circuits de liquide (2, 3) étant séparés l'un de l'autre par au moins une couche (10) rendant étanche les interstices entre les conducteurs de type N et P (6).

7. Dispositif de refroidissement selon la revendication 2, **caractérisé en ce que** le circuit de liquide (2, 3) comporte un réservoir tampon frigorifique.
